# EUROPEAN PATENT APPLICATION

(11) **EP 0 644 601 A2**
(43) Date of publication of application: **22.03.1995**
(21) Application number: 94114706.8
(22) Date of filing: 19.09.1994
(51) Int. Cl.: H01L 39/24

(54) **Oxide superconductor and method of fabricating the same**

(30) Priority: 20.09.1993 JP 232779/93
(71) Applicant: HITACHI, LTD., Chiyoda-ku, Tokyo 100 (JP)
(72) Inventor: Okada, Michiya, Ibaraki 311-11 (JP); Tanaka, Kasuhide, Hitashi-shi 319-12, (JP); Fukushima, Keiji, Ibaraki 316 (JP); Kamo, Tomoichi, Ibaraki 319-11 (JP)
(74) Representative: Altenburg, Udo, Dipl.-Phys.

(57) **Abstract**

According to various embodiments of the present invention, there is provided: a superconductor has a sectional structure composed of a superconductor phase, metal phase and an insulating phase, wherein the volume of the insulating phase is expanded in a heat-treatment process by the phase-conversion of crystals of the insulating phase; thus, it is possible to achieve the densifying by heat-treatment after coil winding, and to obtain a superconductor less in alternating current loss.

## Description

### BACKGROUND OF THE INVENTION

The present invention relates to an oxide superconductor and its fabrication method, and particularly to a new oxide superconductor suitable for a twisted cable structure and its fabrication method.

It is well known that oxide superconductors have a lot of properties superior to conventional metal materials. In particular, they have critical temperatures Tc higher than the liquid nitrogen temperature and critical magnetic fields more than 30 tesla. These characteristics of oxide superconductors make it possible to generate a ultra high magnetic field of 25 tesla or more which has been impossible to be obtained by conventional metal materials, and to realize a superconductive magnetic system by cooling using liquid nitrogen. The coil of such a high temperature superconductor is fabricated by the so-called winding-and-reacting method described, for example in ("Low Temperature Engineering", Vol. 27, No. 1, 1992, p.70-76), incorporated herein by reference, wherein heat-treatment is performed after winding; or by the so-called reacting-and-winding method described, for example in ("Superconducting Communications", Vol. 12, No. 3, 1993), incorporated herein by reference, wherein winding is performed after heat-treatment.

In each of the references described above, an oxide superconductor coated with silver is formed into a thin tape shape, and the tape-shaped wire is wound into a pan-cake coil. The material of the oxide superconductor is represented by Tl₂Ba₂Ca₂Cu₃Ox and (Bi,Pb)₂Sr₂Ca₂Cu₃Ox. In each case, however, the generated magnetic field of the high temperature superconductor coil is not more than about 1 tesla.

The above references have another disadvantage. As is well known, the repeating of rolling and heat-treatment is effective to simultaneously achieve the densifying and orientation of the superconductor. However, the wire after heat-treatment is generally very weak, tending to generate breaking and folding or to be deformed into a sausage shape at the silver-superconductor interface. This makes it difficult to form a long-sized wire. A further disadvantage of the references lies in that the wire is quite insufficient in its mechanical strength against an electromagnetic stress when actually used, and thus it is difficult to prevent the generation of cracks in a compacting and a bending process. For this reason, the oxide superconductors cannot be formed into a twisted cable structure which can be usually obtained using metal based superconductors. Moreover, the oxide superconductors composed of ceramics have a limitation to the densifying, and thereby contain a lot of voids between particles of filaments. In addition, they are extremely difficult to be formed in a twisted cable structure without harming crystal orientation. The oxide superconductor of the references, therefore, have disadvantages in terms of stability because of heat-generation due to the alternating current loss when being applied to ac wires such as superconductor generators, motors, feed cables, ac magnets and pulse magnets.

Finally, since oxide superconductors are composed of ceramics difficult to be plastically deformed, they have a limitation in forming long-size products and in forming multi-core wires by the conventional drawing and rolling method.

An object of the present invention, therefore, is to provide a wire having a twisted structure being dense and having excellent in mechanical strength, wherein an oxide superconductor can be simultaneously densified and oriented.

A further object of the present invention is to provide an oxide superconductor being dense and less in alternating current loss.

### SUMMARY OF THE INVENTION

The present invention provides a method of fabricating an oxide superconductor including a process of filling a sheath tube with a powder of a superconductor, a process of forming a wire obtained in the filling process into a conductor with a free size, and a process of a heat-treating the conductor. The present invention also provides an oxide superconductor formed according to the above process including a volume variable layer made of metal.

According to one embodiment of the invention, the volume variable layer is formed at a core portion, a superconductor layer made of an oxide-based superconductor is formed around the outer periphery of the volume variable layer, and a sheath layer is formed around the outer periphery of the superconductor layer. The sheath layer preferably does not substantially chemically react with the oxide superconductor in the heat-treatment process.

The volume variable material before heat-treatment is preferably made of a high melting metal such as titanium or zirconium and the alloy thereof; aluminum or an aluminum alloy; titanium alloy, zirconium alloy, steel, or stainless steel, which contains aluminum in an amount of from 1 to 10%. Further the sheath layer is preferably made of metal tin, lead thallium or indium.

According to an embodiment of the invention in which a coil is provided, each of the metal phase, metal phase and insulating phase constituting the conductor preferably has a flat section, and which is laminated to be in parallel to the flat plane. The conductor is preferably wound into a solenoid coil or pan-cake shape, followed by heat-treatment for varying the volume of the volume variable layer. The conductors are preferably collected into a cable or a current lead shape, followed by heat-treatment for varying the volume of the volume variable layer. The insulating phase is preferably formed into a shape of a mesh, wire or tape.

According to a further embodiment of the present invention, there is provideed a high temperature superconductor comprising: an oxide superconductor phase, a metal phase and an insulating phase, wherein the oxide superconductor phase is densified by a new winding-and-reacting method. According to one embodiment of the winding-and-reacting method a material which does not substantially chemically react with the superconductor in the heat-treatment process is used as the insulating phase for the high temperature superconductor and which is expanded in volume. The expansion of the volume of the insulating phase is utilized for pressurizing/compacting the superconductor, thus densifying the superconductor.

Such embodiments make it possible to density the oxide superconductor over the whole length even when it has a long-sized and complex shape, such as the twisted structure and coil shape. Such densification has been previously considered to be impossible. Moreover, the sectional shape of the conductor is not substantially limited, that is, it is not limited to a tape shape which has been conventionally used. According to embodiments using such a property of superconductor crystals that the c-axes of the crystals are arranged perpendicularly to the direction to which a pressurizing force by the expansion in volume is applied, even the wire and coils with the complex shape described above are oriented, by arranging the volume variable type insulating material at a suitable geometric position.

According to some embodiments, the volume variable materials includes metals liable to be oxidized, for example, titanium, zirconium and magnesium, none of which are substantially reactive with the oxide superconductor. According to alternate embodiments, the volume variable materials does not include such metals. In accordance with some embodiments containing such metals, however, they are formed into a shape of tape, powder, tube and mesh. The expansion is generated upon the phase-conversion from metal to metal oxide. Further, according to some embodiments, to adjust the expansion coefficient, there is used a mixture in which a metal is added with the oxide of the metal (previously oxidized).

Acceptable examples of oxide superconductors include, but are not particularly limited to, the following known conductive materials:
(A) Tla-Bab-Cac-Cud-Oe system, where
   (1) a: b: c: d: e = (1.8 - 2.2):(1.8 - 2.2):(1.8 - 2.2):(2.7 - 3.3):(9 - 10),
   (2) a: b: c: d: e = (1.8 - 2.2):(1.8 - 2.2):(0.8 -1.1):(1.8 - 2.2):(7.2 - 8.8),
      and
   (3) a: b: c: d: e = (1.8 - 2.2):(1.8 - 2.2): (0): (0.9 - 1.1): (5.4 - 6.6);
(B) Tla-(Ba₁-x-Srx)b-Cac-Cud-Oe system, where x = 0 - 0.5, and
   (1) a: b: c: d: e = (1.8 - 2.2):(1.8 - 2.2):(1.8 - 2.2):(2.7 - 3.3):(9 - 11),
   (2) a: b: c: d: e = (1.8-2.2):(1.8 - 2.2):(0.9 - 1.1):(1.8 - 2.2):(7 - 9), and
   (3) a: b: c: d: e = (1.8 - 2.2):(1.8 - 2.2):(0):(0.9 - 1.1):(5.4 - 6.6);
(C) Tla-(Ba₁-x-Srx)b-Cac-Cud-Oe system, where x = 0 - 0.5, and
   (1) a: b: c: d: e = (0.8 - 1.2):(1.8 - 2.2):(1.8 - 2.2):(2.7 - 3.3):(9 - 11),
   (2) a: b: c: d: e = (0.8 - 1.2):(1.8 - 2.2):(0.9 - 1.1):(1.8 - 2.2):(7 - 9),
      and
   (3) a: b: c: d: e = (0.8 - 1.2):(1.8 - 2.2):(0):(0.9 - 1.1):(5.4 - 6.6);
(D) (Tl₁-x, pbx)a-(Sr₁-y-Bay)b-Cac-Cud-Oe system, where x = 0 - 0.5, y = 0 - 0.5, and
   (1) a: b: c: d: e = (0.8 - 1.2):(1.8 - 2.2):(1.8 - 2.2):(2.7 - 3.3):(9 - 11),
   (2) a: b: c: d: e = (0.8 - 1.2):(1.8 - 2.2):(0.9-1.1):(1.8 - 2.2):(7 - 9), and
   (3) a: b: c: d: e = (0.8 - 1.2):(1.8 - 2.2):(0):(0.9 - 1.1):(5.4 - 6.6);
(E) (Bi₁-x, pbx)a-Srb-Cac-Cud-Oe system, where x = 0 - 0.5), and
   (1) a: b: c: d: e = (1.8 - 2.2):(1.8 - 2.2):(1.8 - 2.2):(2.7 - 3.3):(9 - 11),
   (2) a: b: c: d: e = (1.8 - 1.2):(1.8 - 2.2):(0.9 - 1.1):(1.8 - 2.2):(7 - 9), and
   (3) a: b: c: d: e = (1.8 - 1.2):(1.8 - 2.2):(0):(0.9 - 1.1):(5.4 - 6.6); and
(F) Ya-Bab-Cuc-Od system, where Y is yttrium or a lanthanide group element, and
   (1) a: b: c: d: e = (1.8 - 2.2):(1.8 - 2.2):(2.8 - 3.2):(6-8).

According to some embodiments, the densified and oriented wire is obtained in the form of a multi-core structure, other than in the form of the conventional single-core tape shaped structure or round shaped structure. In some such embodiments, for example for some the single-core wire and also for the twisted wire and the multi-core wire having a complex section, there is provided a densified and oriented superconductor core by disposing a material expandable in volume under the heat-treatment at a portion of the wire. Moreover, according to even further embodiments, for some conductors with a twisted structure necessary for removing the alternating current loss in ac applications, such as a primary twisted cable, secondary twisted cable, or ternary twisted cable, there is provided an oriented and densified conductor without any deterioration of the superconductivity.

Further still, according to some embodiements of the densifying method of the present invention, utilizing the phase conversion is applied to the conventional tape shaped and round sectional wires. According to one such example, a long-sized wire previously fabricated is laminated on the above phase convertible insulating material, which are formed in a coil and heat-treated, thus fabricating a superconductor coil having a densified section in which crystals are oriented perpendicularly to the winding axis. The coil thus obtained is capable of generating a high magnetic field. The volume varying ratio of the volume variable material is in the range of from 1 to 80%, preferably, in the range of from 5 to 20%. More preferably, the volume variable material is adjusted such that the density of the superconductor core is equal to the true density after compactness.

According to a futher example, in winding a tape shaped conductor, using a transparent winding frame as a winding spool, uniformity in the winding of the phase convertible insulating phase and the silver sheath is improved, and hence defects are reduced, for example, to be 1/50 times or less compared with the conventional one.

According to even further embodiments of the present invention, the phase convertible type conductor of the present invention is used for a magnet, current lead and cable, which are applicable for a superconductor generator, motor, SMES apparatus and NMR apparatus.

The phase convertible type conductor of the present invention is superior in mechanical strength to the conventional one. Namely, the conventional filament having a structure that a powder of superconductor is coated with a silver sheath is disadvantageous in that the yield stress is significantly low, about 1/10 times that of copper, and cannot be used for apparatuses where a strong electromagnetic force such as a magnetic stress is applied. According to some embodiments, the phase convertible type conductor of the present invention enhances the yield stress comparable with that of copper by the mechanical strength of the insulating phase potion made of metal oxide, and thus, the present invention is effective in practical use.

According to some embodiments of the present invention, the metal sheath materials include a silver-based alloy containing silver, gold, palladium and 1-50 wt% of gold; and silver-based or gold-based alloy containing 1 to 50 wt% of palladium or magnesium. Moreover, in some embodiments, a non-magnetic heat-insulating alloy is used as an outermost layer for reinforcement of the structure, as needed. According to still further embodiments, although in general a silver or gold alloy has a problem in drawing or rolling, the problem is solved by using a silver-gold clad, in the ratios discussed above, as the sheath material; thinning it; and alloying it by diffusion reaction at the final heat-treatment.

### DESCRIPTION OF THE DRAWINGS

For a more complete understanding of the present invention and for further advantages thereof, reference is made to the following Detailed Description taken in conjunction with the accompanying drawings, in which:
- Fig. 1: is a schematic view of an example of a conductor having a twisted structure according to the present invention.
- Fig. 2: is a schematic view of an example of a conductor having a two-way twisted structure according to the present invention.
- Fig. 3: is a schematic view of an example of a conductor having a twisted structure with a rectangular section according to the present invention.
- Fig. 4: is a schematic view of an example of a superconductor having a secondary twisted structure according to the present invention.
- Fig. 5: is a sectional view of an example of a superconductor according to the present invention.
- Fig. 6: is a sectional view of an example of a superconductor according to the present invention.
- Fig. 7: is a sectional view of an example of a superconductor having a modified sectional structure according to the present invention.
- Fig. 8: is a sectional view of an example of a superconductor having a modified sectional structure according to the present invention.
- Fig. 9: is a sectional view of an example of a superconductor having a modified sectional structure according to the present invention.
- Fig. 10: is a sectional view of an example of a superconductor having a modified sectional structure according to the present invention.
- Fig. 11: is a sectional view of an example of a superconductor having a modified sectional structure according to the present invention.
- Fig. 12: is a sectional view of an example of a superconductor having a modified sectional structure according to the present invention.
- Fig. 13: is a sectional view of an example of a superconductor having a modified sectional structure according to the present invention.
- Fig. 14: is a sectional view of an example of a superconductor having a modified sectional structure before heat-treatment according to the present invention.
- Fig. 15: is a sectional view of an example of a superconductor having a modified sectional structure according to the present invention.
- Fig. 16: is a fabrication method for an example of a superconductor according to the present invention.
- Fig. 17: is a graph showing a relationship between Jc and the wire diameter for a comparison between an example of a superconductor according to the present invention and a comparative superconductor.
- Fig. 18: is a sectional view of an example of a superconductor having a modified sectional structure according to the present invention.
- Fig. 19: is a sectional view of an example of a superconductor having a modified sectional structure according to the present invention.
- Fig. 20: is a sectional view of an example of a superconductor having a modified sectional structure according to the present invention.
- Fig. 21: is a sectional view of an example of a superconductor having a modified sectional structure according to the present invention.
- Fig. 22: is a schematic view of a superconductor coil using an example of a superconductor according to the present invention.
- Fig. 23: is a schematic view of a winding machine for a superconductor coil using an example of a superconductor according to the present invention.
- Fig. 24: is a schematic view of a superconductor coil using an example of a superconductor according to the present invention.
- Fig. 25: is a schematic view of a superconductor coil system using an example of a superconductor according to the present invention.
- Fig. 26: is a schematic view of a superconductor coil system using an example of a superconductor according to the present invention.
- Fig. 27: is a schematic view of a superconductor coil system using an example of a superconductor according to the present invention.

### EXPLANATION OF SYMBOLS

- 1:: oxide superconductor
- 2:: volume variable material
- 3:: silver sheath material

It is to be noted, however, that the appended drawings illustrate only typical embodiments of this invention and are therefore not to be considered limiting of its scope, for the invention may admit to other equally effective embodiments.

### DETAILED DESCRIPTION

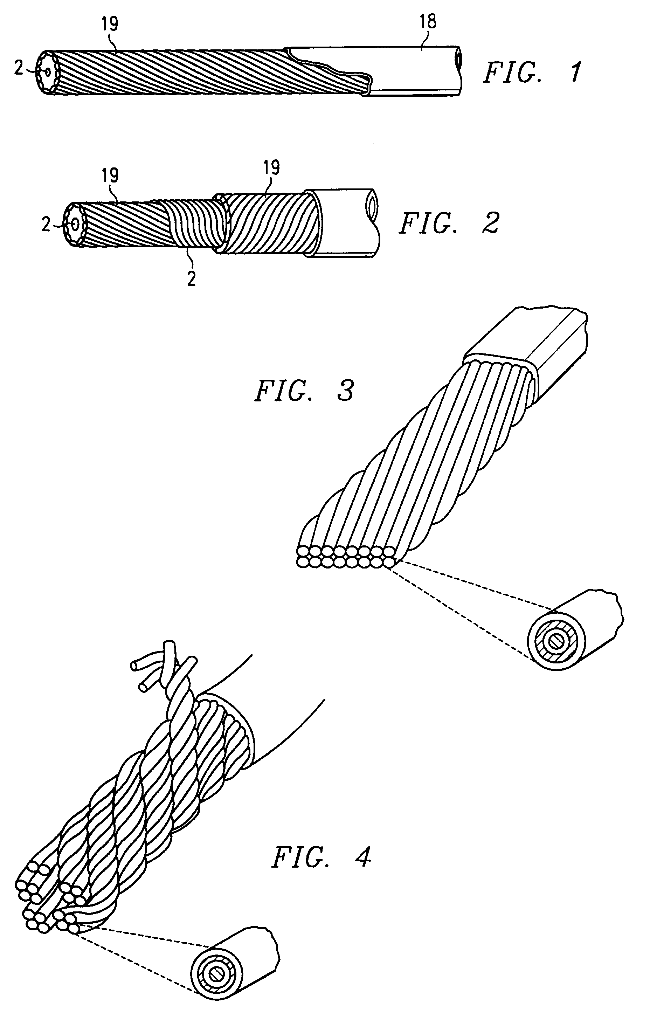

Fig. 1 is an example of a conductor with a twisted structure of the present invention. A tape-shaped wire 19 is wound in the manner shown in the figure.

Fig. 2 is an example of a conductor with a two-way twisted structure of the present invention. The tensile strength of the conductor thus fabricated is 20 kg/mm², which is significantly improved compared with the value of 8 kg/mm² of the conventional conductor to which a volume variable material is not added.

Fig. 3 is an example of a twist cable having a rectangular section using the wires of the present invention.

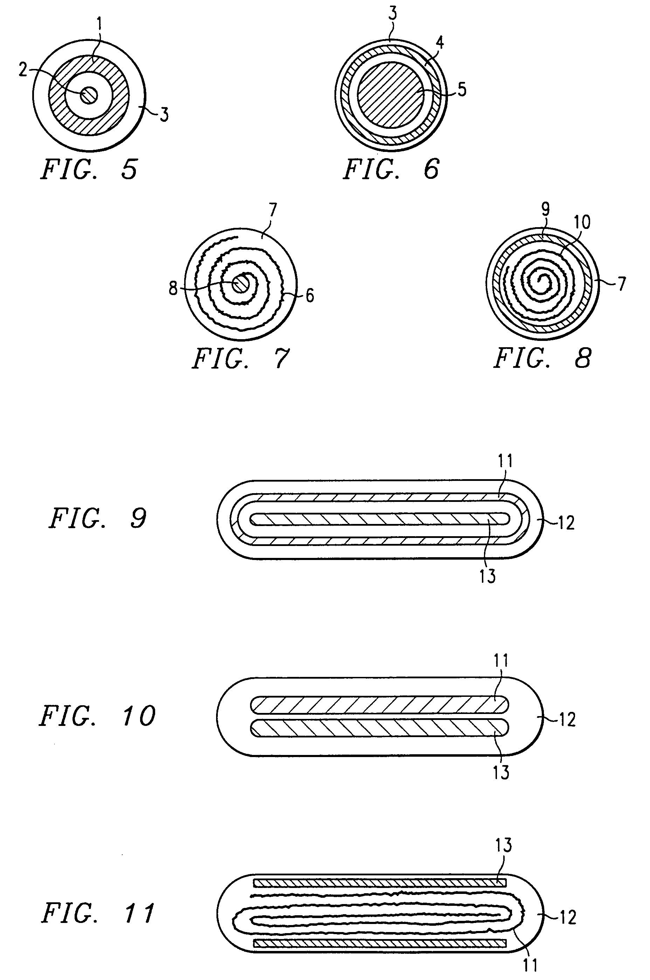

Fig. 4 is an example of a secondary twisted cable using the wires of the present invention. The wires can be each densified and are twisted without any deterioration of the performance. Moreover, the wires of the present invention can be twisted by the conventional method used for metal-based wires.

Fig. 5 is a transverse sectional view of an example of a wire of the present invention, which shows the state after the final heat-treatment. Titanium oxide 2 as the phase convertible material is disposed inside an annularly disposed filament 1 made of Tl₂(Ba_{0.8},Sr_{0.4})₂Ca_{2.1}Cu₃O₁₀, and silver is disposed between the filament 1 and the titanium oxide 2 to prevent the contact therebetween. Silver as the sheath material is disposed around the outermost periphery of the wire. The phase convertible material before heat-treatment is in the form of metal titanium, which has a volume of about 1/2 that of the titanium oxide. Metal titanium is converted into titanium oxide by heat treatment in an oxidizing atmosphere. The filament 1 made of superconductor is pressurized at a high temperature by the volume expansion due to the phase conversion from metal titanium to titanium oxide, thus obtaining a densified structure.

The densification is not dependent on the wire diameter. Accordingly, there can be obtained a fine wire having a diameter in the range of 100 µm or less, preferably, in the range of 0.1 to 30 µm without any deterioration of the performance.

According to some embodiments of the invention, a mixed powder of metal titanium and volume invariable oxide is used in order to adjust the expansion ratio of the phase convertible material. For example, the combination of alumina powder and metal titanium, or the combination of titanium oxide and metal titanium is effectively used. In this case, the expansion coefficient, which is dependent on the phase conversion of metal titanium, is adjusted to be in the range of from 1/100 to 1/2.

Fig. 6 is a sectional view of an example of a wire of the present invention, which shows the state after heat treatment, according to one embodiment. Oxide 5 of (Tl_{0.5}, Pb_{0.5})₂Sr_{2.0}Ca_{2.2}Cu₃O₉ is disposed at the center portion, and a mixture 4 of nickel oxide and zirconia is disposed outside the oxide 5. In the mixed powder, zirconia and metal nickel are in the mixing ratio of 50:50 wt%, and only nickel is phase-converted into nickel oxide. According to some embodiments, the volume varying ratio of the phase convertible material is adjusted by the addition of a phase inconvertible material thereto. In general, to fill gaps in the superconductor, the volume expansion ratio is in the range of about 10 to 200 vol%, preferably, in the range of 10 to 50 vol%.

Fig. 7 is a transverse sectional view of an example of a wire of the present invention. As the oxide superconductor, Bi_{2.1}Sr₂Ca_{1.2}Cu₂O₈, designated at numeral 6, is used. Magnesia 8 as the phase convertible material is disposed at the center of the wire. Fig. 7 shows the state phase after heat treatment. Convertible material 8 before heat-treatment is in the form of metal magnesium. Because silver-gold alloy is difficult to draw, a clad of gold pipe and silver pipe is used. The structure is then drawn, and, after drawing, the structure is heat treated. During heat treatment, metal magnesium is phase-converted into magnesia. The gold and silver clads are used in amounts sufficient to result in a gold-silver alloy after heat treatment of about 8wt% gold is used. This embodiment is useful in applications such as current leads and current coil switches.

Fig. 8 shows an example using an oxide superconductor made of Bi_{1.8}Pb_{0.4}Sr₂Ca_{2.2}Cu₃O₁₀ designated at numeral 10, and a phase convertible material made of tin 9. In this example, a mixed powder of tin and tin oxide is used, in which the mixing ratio of tin is 10 wt% based on the total tin oxide. Tin is oxidized in the final heat-treatment, to be converted into tin oxide.

Figs. 9, 10 and 11 are sectional views of examples of wires of the present invention. These examples are different in sectional shape from each other. However, in each of the examples, Y₁Ba₂Cu₃O₁₀ designated at numeral 11 is used as an oxide superconductor; an alloy 12 of Ag and Pd (2% by wt Pd) is used as a sheath material; and niobium 13 is used as a phase convertible material.

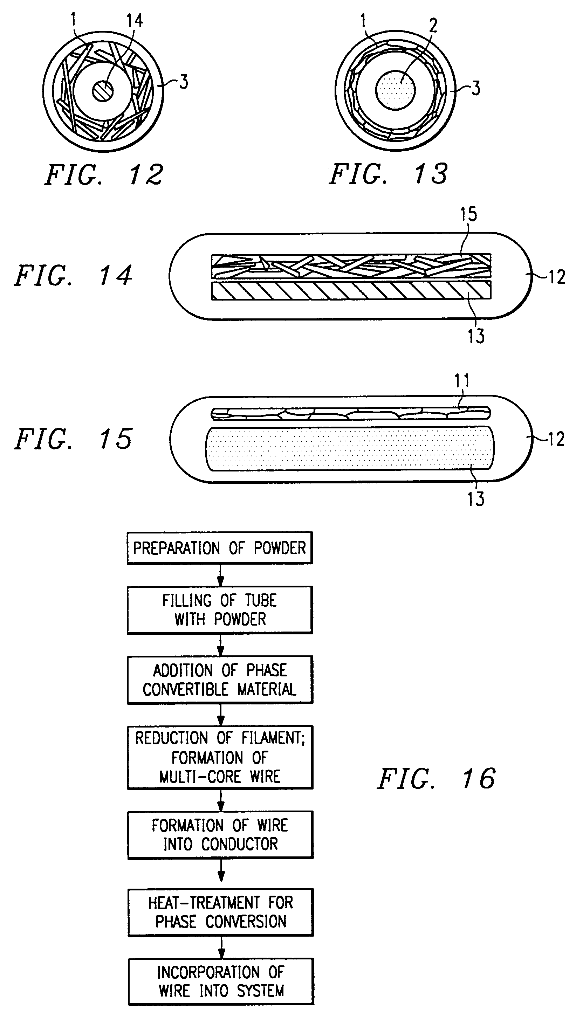

Figs. 12 and 13 are sectional views, having the same sectional construction as in Fig. 5, which show a comparative example of the effect of using an un-oxidized metal in forming the structure, which is oxidized during heat treatment. According to the example of Fig. 12, TiO₂ powder 14, previously oxidized, is disposed at the center portion of the wire. The structure is then heat treated. Because the titania (TiO₂) is not phase-converted in the final heat-treatment, there is no expansion in volume. Therefore, as shown in Fig. 12, gaps remain in oxide crystals 1, and therefore, the oxide crystals 1 are not well oriented. By contrast, Fig. 13 shows an example in which the volume expansion occurs by the phase conversion as in the case using metal titanium. Oxide crystals are radially compressed by heat-treatment, and are orientated in the *c*-faces thereof. That is, the transmission faces of electrons perpendicularly to the compression direction; and further, they are simultaneously densified.

Fig. 14 is a sectional view of an example of a tape-shaped wire before phase conversion, which has the same sectional construction as in Fig. 10.

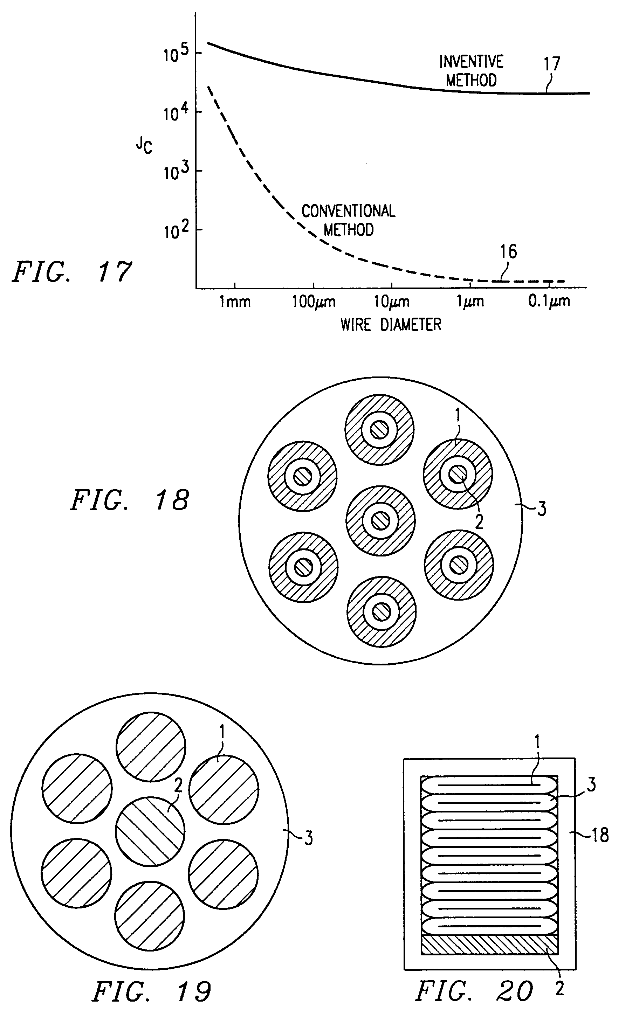

Fig. 15 shows the tape-shaped wire after phase conversion. As shown in Fig. 15, the gaps existing before the phase conversion are densified by heat-treatment, and the *c*-faces of crystals are orientated along the tape surface.
Fig. 16 is a flow-sheet showing a fabricating process for a wire of the present invention. In the procedure, a sheath tube is filled with a powder of superconductor. At this time, a phase convertible material is simultaneously added. The tube is then thinned. After that, a multi-core wire may be formed, as needed. The wire is then formed into a conductor. The conductor is phase-converted by heat-treatment, and is incorporated in a superconductor system.

The final heat-treatment is preferably performed for 1 to 500 hr at a sintering temperature suitable for the superconductor ranging from 700 to 950 degrees C in an oxidizing atmosphere such as a 2-100% oxygen atmosphere.

Acceptable phase convertible materials capable of being expanded in volume by heat-treatment and not reacting with the superconductor include, for example, titanium, zirconium, thallium, indium, hafnium, nickel, manganese, magnesium, tin, lead, silicon, chromium, niobium-titanium compound, and the alloys thereof (for example: aluminum or aluminum alloy; and titanium alloy, zirconium alloy, hafnium alloy, steel or stainless steel containing 1 - 10% aluminum).

According to alternate embodiments the phase convertible material is used in the form of powder, tape and/or mesh. Acceptable oxide superconductors include materials shown in Table 1

**Table 1**

| | Contents | Criticial Temperature (K) |
|---|---|---|
| La | La_{1.8}Ba_{0.2}Cu₁O₄ | 30 |
| | La_{1.8}Sr_{0.2}Cu₁O₄ | 40 |
| | La_{1.8}Ca_{0.2}Cu₁O₄ | 30 |
| | La_{1.8}Na_{0.2}Cu₁O₄ | 40 |
| | La_{1.8}Cu₁O₄ | 40 |
| Y | Y₁Ba₂Cu₃O₇ | 94 |
| | Y₁Ba₂Cu₃O₇ | 80 |
| | Ln₁Ba₂Cu₃O₇ | 90 |
| | Ca₁Ba₁La₁Cu₃O₇ | 80 |
| | Y₂Ba₄Cu₃O₇ | 80 |
| Bi | Bi₂Sr₂Cu₁O₆ | 7 |
| | Bi₂Sr₂Ca₁Cu₂O₆ | 80 |
| | Bi₂Sr₂Ca₂Cu₃O₁₀ | 110 |
| Tl | Tl₂Ba₂Cu₁O₆ | 90 |
| | Tl₂Ba₂Ca₁Cu₂O₆ | 105 |
| | Tl₂Ba₂Ca₂Cu₃O₁₀ | 122 |
| | Tl₂Ba₂Ca₃Cu₄O₁₂ | 117 |
| | Tl₁Ba₂Cu₁O₅ | 20 |
| | Tl₁Ba₂Ca₁Cu₂O₇ | 91 |
| | Tl₁Ba₂Ca₂Cu₃O₉ | 116 |
| | Tl₁Ba₂Ca₃Cu₄O₁₁ | 122 |
| | Tl₁Ba₂Ca₄Cu₅O₁₃ | 117 |
| | Tl₁Ba₂Ca₁Cu₂O₇ | 75 |
| | Tl₁Ba₂Ca₂Cu₃O₇ | 100 |
| | Tl_{0.8}Pb_{0.2}Sr₂Ca₁Cu₂O₇ | 90 |
| | Tl_{0.8}Pb_{0.2}Sr₂Ca₁Cu₈O₉ | 120 |

Fig. 17 shows a relationship between the wire diameter and the critical current density. In the reduction process designated at numeral 16 by the conventional powder rolling, powder is mechanically densified by only drawing using dies or rolling, as a result of which Jc of the wire is reduced by the reduction. On the other hand, in example 17, in the reduction of the wire, the micro-gaps of the wire are applied with a chemical pressurizing force due to the expansion generated by the sufficient phase conversion, so that the wire is not deteriorated in the performance by the reduction. The present invention is, therefore, more effective than the conventional wire, in the case of the multi-core wire, and particularly in the case of multi-core fine wire.

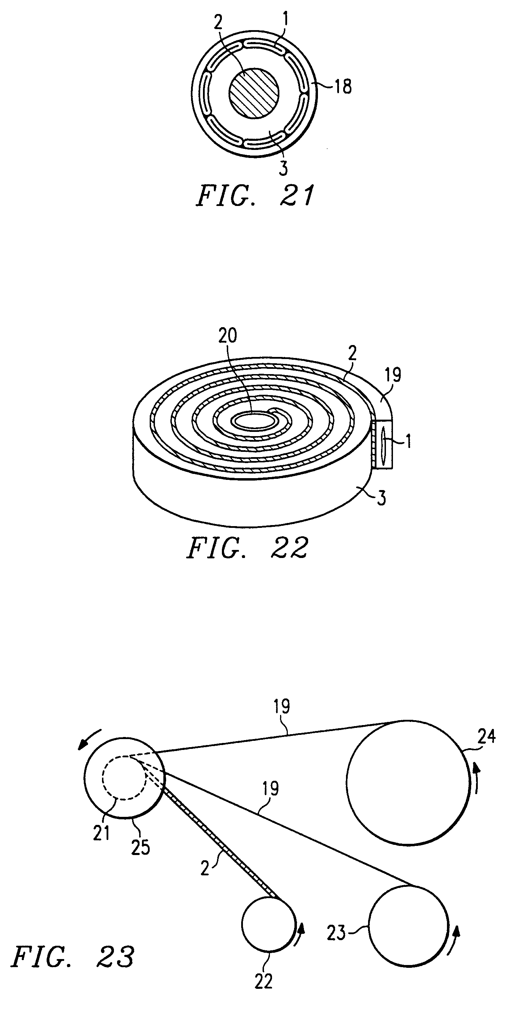

Figs. 18, 19, 20 and 21 are transverse sectional views of examples of multi-core wires of the present invention. Fig. 18 shows a wire in which 7 pieces of filaments shown in Fig. 5 are collected. Fig. 19 shows the multi-core wire in which a phase convertible material is disposed at the center. Fig. 20 shows the multi-core wire in which tape-shaped conductors are collected, wherein a phase convertible material 2 is disposed such that a pressurizing force generated by phase conversion is applied perpendicularly to the tape surface, and the wire is coated with stainless steel 18 as a whole. Fig. 21 shows an example of a multi-core wire in which tape-shaped conductors are collected in a round shape. Using the wires of the present invention, there can be realized a twisted cable structure in which the alternating current loss is lowered.

Fig. 22 shows an example in which the phase converting method of the present invention is applied to the densifying for a pan-cake coil fabricated using a tape shaped wire. As shown in this figure, a phase convertible material 2 is overlappingly wound on a tape shaped wire 19. Silver 20 is used as a winding core. The pan-cake coil thus obtained is heat-treated, to realize a superconductor coil which is densified and oriented in the *c*-faces of crystals along the winding peripheral direction. The thickness of the tape shaped wire material is preferably in the range of from 0.05 to 0.2 mm. According to some embodiments, the tape shaped wires in the number of 2 to 6 pieces are laminated. The phase convertible material is made of a tape shaped metal, and preferably it has a thickness ranging from 10 to 100 µm.

Referring now to Fig. 23, there is shown a winding machine useful for fabrication of a pan-cake coil. The tape shaped phase convertible material 2 is fed from a feed portion 22 with a specified tension. The wires 19 are fed from the feed portions 23 and 24 with a specified tension. The coil is wound around a winding portion 21. By use of a winding frame 25, made of transparent plastic or the like, it is possible to extremely easily find defects of the coil upon winding, to increase the quality of the coil, and hence to extremely enhance the manufacturing yield by 20 times that of the conventional method.

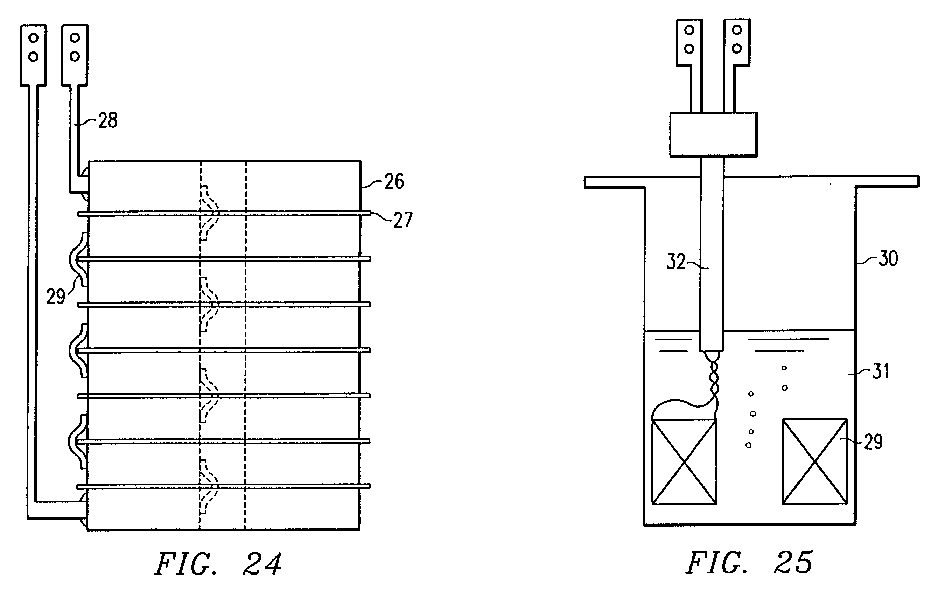

Fig. 24 shows an example of a coil system of the present invention in which 8 pieces of the pan-cake coils 26 thus fabricated are laminated. The pan-cake coils are separated from each other by means of alumina plates 27, and are connected to each other by means of silver tapes 29. According to alternative embodiments, the silver tape is replaced by a superconductor wire. The coil generates 3 tesla at 63 K.

Fig. 25 shows an example of a solenoid coil system fabricated using the twisted cable shown in Fig. 4. A solenoid coil 29 is disposed within a cryostat 30, and is dipped in liquid helium 31. A current lead 32 is made of a two-way twisted conductor shown in Fig. 2. The coil system generates 5 tesla at 4.2 K.

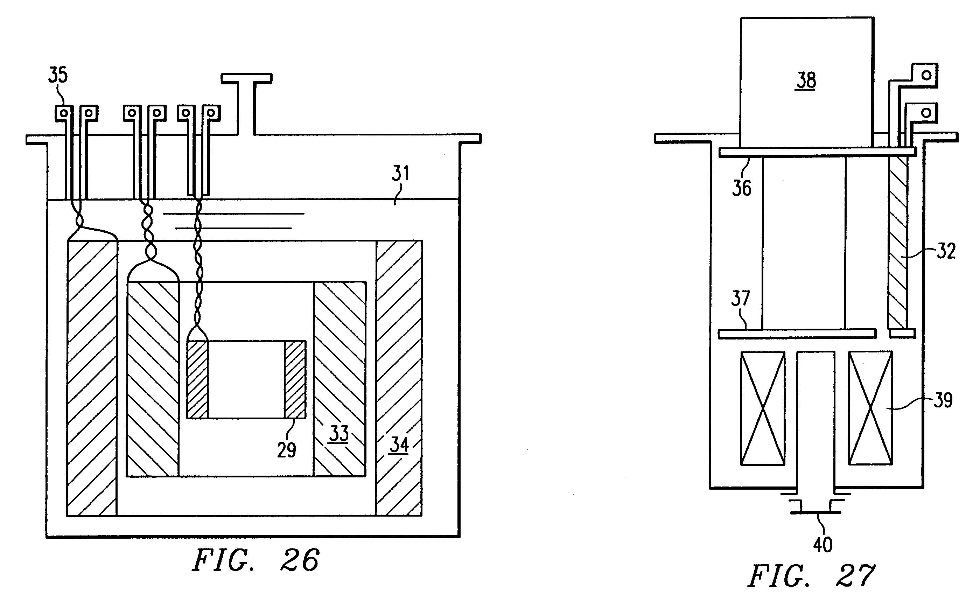

Fig. 26 is a system composed of a niobium-titanium compound coil 34, niobium-tin compound coil 33 and an oxide superconductor 29. A current lead is made of a twisted conductor shown in Fig. 3, and is disposed as shown in Fig. 26. The coil generates 25 tesla at 4.2 K.

Fig. 27 is an example of a coil system combined with a helium refrigerator. The pan-cake coil shown in Fig. 25 is used as a superconductor coil 39.

In Fig. 27, a two-way twisted conductor shown in Fig. 2 is used as a current lead. In the refrigerator, the current lead is kept to be 70 K at the portion of a first stage, and to be 20 K at a second stage. The cryostat is evacuated and heat-insulated, and a magnet is kept at 20 K. By opening a flange 40, there can be obtained a magnetic field of 3 tesla in a room temperature space. Moreover, according to some embodiments, the system shown in this figure is used in the state to be vertically reversed or to be tilted, that is, it is not limited in terms of the geometrical disposition.

The coil systems described above are only illustrative, and may be applied to ac superconducting fields, such as an NMR, MRI, SMES, superconductor generator, superconductor motor, accelerator and the like.

The present invention provides a wire of a twisted structure being dense and excellent in mechanical strength, wherein the wire can be simultaneously densified and oriented.

## Claims

1. A method of fabricating a superconductor comprising:
confining a superconductor material between a volume variable material and a non-volume variable material, and
causing the volume variable material to expand in volume.

2. A method of fabricating as in claim 1, further comprising:
forming a core comprising a metal chosen from a group consisting essentially of: Ti, V, Cr, Mn, Fe, Co, Ni, Cu, Zn, Al, Mg, Zr, Nb, and Sn,substantially surrounded by a noble metal;
placing the core inside a sheath tube, such that there is a gap between the core and the inside wall of the sheath tube; and filling the gap with a powder of a superconductor, whereby a filled sheath tube is defined.

3. A method as in claim 2, further comprising reduction of the sheath tube.

4. A method as in claim 2 or 3, further comprising:
forming the filled sheath tube into a conductor shape; and heat treating the conductor shape.

5. A method of fabricating as in any of claims 1 to 4, further comprising:
placing an oxide superconductor in a sheath tube;
placing a volume variable material in the sheath tube; and
reduction the sheath tube.

6. A method as in any of claims 1 to 5, further comprising:
forming the reduced sheath tube into a conductor; and
heat treating the formed conductor.

7. A method as in one of the preceding claims 1 to 6, wherein said superconductor substantially surrounds said volume variable material.

8. A method as in one of the preceding claims 1 to 7, wherein said volume variable material substantially surrounds said superconductor.

9. A method as in one of the preceding claims 1 to 8, wherein said volume variable material is chosen from the group: Ti, V, Cr, Mn, Fe, Co, Ni, Cu, Zn, Al, Mg, Zr, Nb, and Sn.

10. A method as in one of the claims 1 to 9, wherein said superconductor comprises an oxide superconductor.

11. A superconductor made according to the method of claims 1-10.

12. A superconductor comprising:
a volume variable layer comprising metal at a core portion,
a superconductor layer comprising a superconductor material around the outer periphery of said volume variable layer, and a sheath layer around the outer periphery of said superconductor layer.

13. A superconductor according to claim 12, wherein said sheath layer does not substantially chemically react with a phase of said superconductor in a heat-treatment process.

14. A superconductor according to claim 12 or 13, wherein said volume variable material is formed from a heat-treatment process and comprises, before the heat-treatment process, a high melting point metal.

15. A superconductor according to claim 14, wherein said high melting point metal comprises a material selected from a group consisting of titanium, titanium alloy, zirconium, zirconium alloy, aluminum, aluminum alloy, steel, stainless steel.

16. A superconductor according to claim 14, wherein said high melting point metal comprises aluminum in an amount from about 1% to about 10%.

17. A superconductor according to claim 12, wherein said sheath layer comprises metal.

18. A superconductor according to claim 17, wherein said metal comprises a material selected from a group consisting of tin, lead thalium, and indium.

19. A superconductor according to claim 12, wherein said superconductor phase, said metal phase and said insulating phase have a flat laminated sections.

20. A superconductor according to claim 12, wherein said conductor is wound into a solenoid coil, followed by heat-treatment or into a pan-cake shape, followed by heat-treatment.

21. A superconductor according to claim 12, wherein said conductors comprise a heat-treated cable or a heat-treated current lead shape.

22. A superconductor according to claim 12, wherein said insulating phase has a mesh shape, a wire shape or a tape shape.

23. A superconductor comprising:
a superconductor layer comprising a superconductor material a core portion,
a volume variable layer comprising metal around the outer periphery of said superconductor layer, and
a sheath layer around the outer periphery of said volume variable layer.

24. A superconductor according to claim 23, wherein said sheath layer does not substantially chemically react with a phase of said superconductor in a heat-treatment process.

25. A superconductor according to claim 23 or 24, wherein said volume variable material is formed from a heat-treatment process and comprises, before the heat-treatment process, a high melting point metal.

26. A superconductor according to claim 25, wherein said high melting point metal comprises a material selected from a group consisting of titanium, titanium alloy, zirconium, zirconium alloy, aluminum, aluminum alloy, steel, or stainless steel.

27. A superconductor according to claim 25, wherein said high melting point metal comprises aluminum in an amount from about 1% to about 10%.

28. A superconductor according to claim 23 or 24, wherein said sheath layer comprises metal.

29. A superconductor according to claim 28, wherein said metal comprises a material selected from a group consisting of tin, lead thalium, or indium.

30. A superconductor according to claim 23 or 24, wherein said superconductor phase, said metal phase and said insulating phase have a flat laminated sections.

31. A superconductor according to claim 23 or 24, wherein said conductor is wound into a solenoid coil, followed by heat-treatment or into a pan-cake shape, followed by heat-treatment.

32. A superconductor according to claim 23 or 24, wherein said conductors comprise a heat-treated cable heat-treated current lead shape.

33. A superconductor according to claim 23 or 24, wherein said insulating phase has a mesh shape, a wire shape or a tape shape.
